# EUROPEAN PATENT APPLICATION

(11) **EP 4 401 136 A1**
(43) Date of publication of application: **17.07.2024**
(21) Application number: 23216839.3
(22) Date of filing: 14.12.2023
(51) Int. Cl.: H01L 25/075, H10K 59/131, H01L 25/16

(54) **DISPLAY DEVICE**

(30) Priority: 28.12.2022 KR 20220187263
(71) Applicant: LG Display Co., Ltd., Seoul 07336 (KR)
(72) Inventor: Eom, HyeSeon, 10845 Gyeonggi-do, (KR); Nam, JuHyun, 10845 Gyeonggi-do (KR); Jang, Hun, 10845 Gyeonggi-do, (KR)
(74) Representative: Ter Meer Steinmeister & Partner

(57) **Abstract**

According to an aspect of the present disclosure, a display device includes: a substrate (110) including a display area (AA) in which a plurality of subpixels is disposed, and a non-display area (NA) disposed to surround the display area and including a plurality of pad areas; a plurality of pads disposed in the plurality of pad areas; a plurality of low-potential power link lines (160) electrically connected to the pads disposed in leftmost and rightmost areas among the plurality of pad areas; a plurality of first assembling lines (121) and a plurality of second assembling lines (122) respectively disposed on the plurality of subpixels and electrically connected to the plurality of low-potential power link lines (160); and a plurality of light-emitting elements disposed on the plurality of first assembling lines (121) and the plurality of second assembling lines (122), in which each of the plurality of low-potential power link lines (160) includes: a first part (160a) connected to the plurality of first assembling lines or the plurality of second assembling lines; and a second part (160b) configured to transmit a low-potential power voltage to the first part (160a).

## Description

This application claims the priority of Korean Patent Application No. 10-2022-0187263 filed on December 28, 2022, in the Korean Intellectual Property Office.

### BACKGROUND

### Field

The present specification relates to a display device, and more particularly, to a display device in which a light-emitting diode (LED) is self-assembled.

### Description of the Related Art

As display devices used for a monitor of a computer, a TV set, a mobile phone, and the like, there are an organic light-emitting display (OLED) configured to autonomously emit, and a liquid crystal display (LCD) that requires a separate light source.

The range of application of the display devices is diversified from the monitor of the computer and the TV set to personal mobile devices, and studies are being conducted on the display devices having wide display areas and having reduced volumes and weights.

In addition, recently, a display device including a light-emitting diode (LED) has attracted attention as a next-generation display device. Because the LED is made of an inorganic material instead of an organic material, the LED is more reliable and has a longer lifespan than a liquid crystal display device or an organic light-emitting display device. In addition, the LED may be quickly turned on or off, have excellent luminous efficiency, high impact resistance, and great stability, and display high-brightness images.

### SUMMARY

An object to be achieved by the present disclosure is to provide a display device in which a voltage drop with respect to a low-potential power voltage is minimized.

Another object to be achieved by the present disclosure is to provide a display device in which power consumption is reduced and image quality is improved.

Still another object to be achieved by the present disclosure is to provide a display device in which a low-potential power line may be configured by a line made of a metallic material instead of a transparent electrode having relatively high resistance.

Yet another object to be achieved by the present disclosure is to provide a display device capable of controlling low-potential power voltages to be applied to a plurality of subpixels that emits light beams with different colors.

Objects of the present disclosure are not limited to the above-mentioned objects, and other objects, which are not mentioned above, can be clearly understood by those skilled in the art from the following descriptions.

The objects are solved by the features of the independent claims. Preferred embodiments are given in the dependent claims.

According to an aspect of the present disclosure, a display device includes: a substrate including a display area in which a plurality of subpixels is disposed, and a non-display area disposed to surround the display area and including a plurality of pad areas; a plurality of pads disposed in the plurality of pad areas; a plurality of low-potential power link lines electrically connected to the pads disposed in leftmost and rightmost areas among the plurality of pad areas; a plurality of first assembling lines and a plurality of second assembling lines respectively disposed on the plurality of subpixels and electrically connected to the plurality of low-potential power link lines; and a plurality of light-emitting elements disposed on the plurality of first assembling lines and the plurality of second assembling lines, in which each of the plurality of low-potential power link lines includes: a first part connected to the plurality of first assembling lines or the plurality of second assembling lines; and a second part configured to transmit a low-potential power voltage to the first part.

Other detailed matters of the exemplary embodiments are included in the detailed description and the drawings.

According to the exemplary embodiment of the present specification, the lines, which are used to self-assemble the plurality of light-emitting elements and apply the low-potential power voltages to the plurality of light-emitting elements, may be made of the same material as the constituent elements disposed on the drive circuit, thereby minimizing the number of transparent electrodes to be used.

According to the exemplary embodiment of the present specification, the low-potential power line and the low-potential power link line may be made of metallic materials having low resistance, thereby reducing a voltage drop with respect to the low-potential power voltage.

According to the exemplary embodiment of the present specification, it is possible to minimize a low-potential power voltage drop and minimize an increase in power consumption.

According to the exemplary embodiment of the present specification, it is possible to apply different low-potential power voltages to the plurality of subpixels that emits light beams with different colors.

In the following optional feature are provided which can be combined with the above mentioned aspects of the disclosure alone, in combination or sub combination.

In one or more embodiments, the plurality of pad areas may be positioned at an upper side of the display area.

In one or more embodiments, the first part may be disposed in the non-display area between the plurality of pad areas and the display area or in the non-display area opposite to the plurality of pad areas.

In one or more embodiments, the second part may be disposed in the non-display area at left and right sides of the display area.

In one or more embodiments, an extension direction of the first part may intersect an extension direction of the plurality of first assembling lines and an extension direction of the plurality of second assembling lines.

In one or more embodiments, at least a part of the second part may be parallel to the extension direction of the plurality of first assembling lines and the extension direction of the plurality of second assembling lines.

In one or more embodiments, the display device may further comprise a plurality of transistors disposed on the plurality of subpixels and each comprising a gate electrode, a source electrode, a drain electrode, and an active layer; and a light-blocking layer disposed between the plurality of transistors and the substrate.

In one or more embodiments, the plurality of low-potential power link lines may be made of the same material as at least one of the light-blocking layer, the source electrode, the drain electrode, the plurality of first assembling lines, and the plurality of second assembling lines.

In one or more embodiments, the first part may be made of the same material as the plurality of first assembling lines and the plurality of second assembling lines.

In one or more embodiments, the second part may comprise a first layer made of the same material as the light-blocking layer; and a second layer connected in parallel to the first layer and made of the same material as the source electrode and the drain electrode.

In one or more embodiments, some of the plurality of first assembling lines may each comprise a jumping pattern disposed in an area in which some of the plurality of first assembling lines intersect another first assembling line.

In one or more embodiments, some of the plurality of second assembling lines may each comprise a jumping pattern disposed in an area in which some of the plurality of second assembling lines intersect another second assembling line.

In one or more embodiments, the first layer may be disposed on an entire area of the second part.

In one or more embodiments, the second layer may be disposed only at a left or right side of the display area.

In one or more embodiments, the plurality of first assembling lines may be each connected to the first part of each of the plurality of low-potential power link lines disposed in the non-display area between the plurality of pad areas and the display area.

In one or more embodiments, the plurality of second assembling lines may be each connected to the first part of each of the plurality of low-potential power link lines disposed in the non-display area opposite to the plurality of pad areas.

In one or more embodiments, the plurality of first assembling lines and the plurality of second assembling lines may be alternately disposed in the display area.

In one or more embodiments, one of the plurality of first assembling lines and one of the plurality of second assembling lines may be connected to the same light-emitting element among the plurality of light-emitting elements.

In one or more embodiments, the plurality of low-potential power link lines may each further comprise a third part connected directly to the pad.

In one or more embodiments, the same voltages may be applied to the second parts of the plurality of low-potential power link lines through the third parts.

In one or more embodiments, the plurality of subpixels may comprise a plurality of first subpixels, a plurality of second subpixels, and a plurality of third subpixels.

In one or more embodiments, the plurality of low-potential power link lines may comprise a first low-potential power link line electrically connected to the light-emitting element of each of the plurality of first subpixels; a second low-potential power link line electrically connected to the light-emitting element of each of the plurality of second subpixels; and a third low-potential power link line electrically connected to an element of each of the plurality of third subpixels.

In one or more embodiments, different voltages may be applied to the first low-potential power link line, the second low-potential power link line, and the third low-potential power link line.

In one or more embodiments, each of the plurality of low-potential power link lines may further comprise a plurality of third parts connected to the second part.

In one or more embodiments, the third part of the first low-potential power link line, the third part of the second low-potential power link line, and the third part of the third low-potential power link line may be connected to different pads.

In one or more embodiments, the display device may further comprise a planarization layer configured to cover the plurality of low-potential power link lines; and a plurality of pixel electrodes disposed on the planarization layer and connected to the plurality of light-emitting elements.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a schematic configuration view of a display device according to an exemplary embodiment of the present specification;
FIG. 2A is an enlarged top plan view of the display device according to the exemplary embodiment of the present specification;
FIG. 2B is a cross-sectional view taken along lines A-A' and B-B' in FIG. 2A;
FIG. 3A is an enlarged top plan view of area IIIa in FIG. 1;
FIG. 3B is an enlarged top plan view of area IIIb in FIG. 1;
FIG. 3C is a cross-sectional view taken along line C-C' in FIG. 3B;
FIG. 3D is a cross-sectional view taken along line D-D' in FIG. 3B;
FIG. 4A is an enlarged top plan view of area IVa in FIG. 1;
FIG. 4B is a cross-sectional view taken along line E-E' in FIG. 4A;
FIG. 5 is a schematic configuration view for explaining a process of manufacturing the display device according to the exemplary embodiment of the present specification; and
FIG. 6 is an enlarged top plan view of a display device according to another exemplary embodiment of the present specification.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as 'including', 'having', 'consist of used herein are generally intended to allow other components to be added unless the terms are used with the term 'only'. Any references to singular may include plural unless expressly stated otherwise.

Components are interpreted to include an ordinary error range even if not expressly stated.

When the position relation between two parts is described using the terms such as 'on', 'above', 'below', 'next', one or more parts may be positioned between the two parts unless the terms are used with the term 'immediately' or 'directly'.

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, various embodiments of the present disclosure will be described in detail with reference to accompanying drawings.

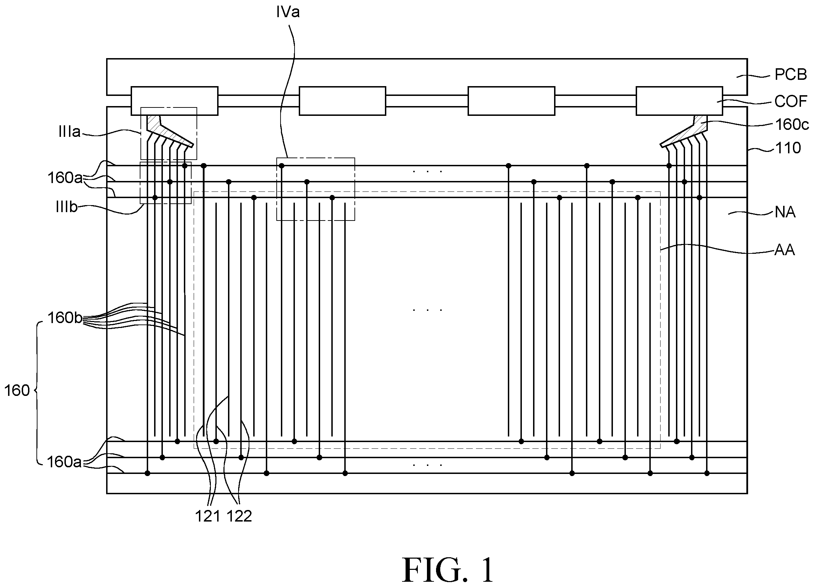

FIG. 1 is a schematic configuration view of a display device according to an exemplary embodiment of the present specification. For convenience of description, FIG. 1 illustrates only a substrate 110, a printed circuit board PCB, a flexible film COF, a display area AA, a non-display area NA, a plurality of low-potential power link lines 160, a plurality of first assembling lines 121, and a plurality of second assembling lines 122 among various constituent elements of a display device 100.

With reference to FIG. 1, the display device 100 includes the substrate 110, the printed circuit board PCB, the flexible film COF, the plurality of low-potential power link lines 160, the plurality of first assembling lines 121, and the plurality of second assembling lines 122.

The substrate 110 is a component for supporting various constituent elements included in the display device 100 and may be made of an insulating material. For example, the substrate 110 may be made of glass, resin, or the like. In addition, the substrate 110 may include plastic such as polymer and may be made of a material having flexibility.

The substrate 110 includes the display area AA and the non-display area NA.

The display area AA is an area in which images are displayed. The display area AA may include a plurality of subpixels, and a drive circuit configured to operate the plurality of subpixels.

The plurality of subpixels is minimum units constituting the display area AA. A plurality of light-emitting elements may be respectively disposed in the plurality of subpixels. The plurality of light emitting elements may have different configurations depending on the type of display panel. For example, in case that the display panel is an inorganic light-emitting display panel, the light-emitting element may be a light-emitting diode (LED) or a micro light-emitting diode (micro LED). However, the present disclosure is not limited thereto.

In addition, the drive circuit configured to operate the plurality of subpixels may include driving elements, lines, and the like. For example, the drive circuit may include, but not limited to, a thin-film transistor, a storage capacitor, a gate line, a data line, and the like.

The non-display area NA is an area in which no image is displayed. Various lines and circuits for operating the light-emitting element in the display area AA are disposed in the non-display area NA. For example, the non-display area NA may include, but not limited to, link lines for transmitting signals to the plurality of subpixels and the drive circuit in the display area AA. The non-display area NA may include a drive IC such as a gate driver IC and a data driver IC.

Meanwhile, the non-display area NA may include a plurality of pad areas disposed at one end of the substrate 110. The plurality of pad areas is areas in which a plurality of pads is disposed. The plurality of pads may serve as electrodes for electrically connecting the plurality of flexible films COF and the substrate 110. Therefore, the plurality of flexible films COF and the substrate 110 may be electrically connected by means of the plurality of pads.

The plurality of flexible films COF is disposed at one end of the substrate 110. The plurality of flexible films COF is each a film having various types of components disposed on a base film having flexibility in order to supply signals to the plurality of subpixels and the drive circuit in the display area AA. The plurality of flexible films COF may be electrically connected to the plurality of pads disposed in the plurality of pad areas. The plurality of flexible films COF may be respectively disposed in the plurality of pad areas of the substrate 110 and supply power voltages, data voltage, and the like to the plurality of subpixels and the drive circuit in the display area AA. Meanwhile, FIG. 1 illustrates four flexible films COF. However, the number of flexible films COF may be variously changed in accordance with design. However, the present disclosure is not limited thereto.

The drive ICs such as gate driver ICs and data driver ICs may be disposed on base films of the plurality of flexible films COF. The drive IC is a component configured to process data for displaying the image and process a driving signal for processing the data. For example, the drive IC may be disposed in ways such as a chip-on-glass method, a chip-on-film method, and a tape carrier package method depending on how the drive IC is mounted.

The printed circuit board PCB is a component configured to supply a signal to the drive IC of each of the plurality of flexible films COF. Various types of components for supplying the drive IC with various signals such as driving signals, data signals, and the like may be disposed on the printed circuit board PCB. For example, the printed circuit board PCB may be called a source printed circuit board (source PCB (S-PCB)) on which a data drive part is mounted. A control printed circuit board (control PCB (C-PCB)), on which a timing controller and the like are mounted, may be further connected to the printed circuit board PCB. However, the present disclosure is not limited thereto. Meanwhile, FIG. 1 illustrates a single printed circuit board PCB. However, the number of printed circuit boards PCB may be variously changed in accordance with design. The present disclosure is not limited thereto.

A plurality of link lines may be disposed in the non-display area NA and extend from the plurality of pad areas. The plurality of link lines may be disposed in the non-display area NA to transmit various signals from the flexible film COF. For example, the plurality of link lines may include a gate link line, a data link line, a high-potential power link line, the low-potential power link line 160, and the like. However, the present disclosure is not limited thereto.

The plurality of low-potential power link lines 160 is disposed in the non-display area NA and extends from the plurality of pad areas provided e.g. at some or more of the edges of the substrate. The plurality of low-potential power link lines 160 may be connected to pads disposed in leftmost and rightmost areas among the plurality of pad areas. Further, the same low-potential power voltage may be applied to the plurality of low-potential power link lines 160.

The plurality of low-potential power link lines 160 includes a plurality of first parts 160a, a plurality of second parts 160b, and a third part 160c.

The plurality of first parts 160a is respectively disposed in the non-display area NA between the plurality of pad areas and the display area AA and in the non-display area NA opposite to the plurality of pad areas. The plurality of first parts 160a may be connected to the plurality of second parts 160b, the plurality of first assembling lines 121, and the plurality of second assembling lines 122 that will be described below.

Therefore, during a process of self-assembling the light-emitting element, the plurality of first parts 160a may transmit power, for self-assembling the light-emitting element, to the plurality of first assembling lines 121 and the plurality of second assembling lines 122. After the manufacturing process of the display device 100 is completed, the plurality of first parts 160a may transmit the low-potential power voltages to the plurality of first assembling lines 121 and the plurality of second assembling lines 122.

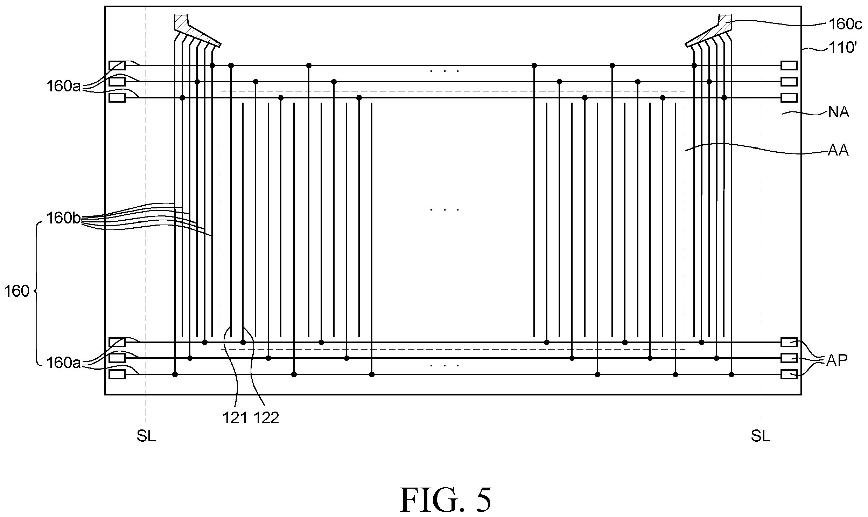

Meanwhile, during the process of self-assembling the light-emitting element, different voltages may be applied to the plurality of first parts 160a, which is disposed in the non-display area NA between the plurality of pad areas and the display area AA, and the plurality of first parts 160a, which is disposed in the non-display area NA opposite to the plurality of pad areas, among the plurality of first parts 160a. However, specific contents thereof will be described with reference to FIG. 5.

The plurality of second parts 160b is parts connected to the first parts 160a of the plurality of low-potential power link lines 160. That is, the plurality of second parts 160b may transmit the low-potential power voltages to the plurality of first parts 160a. With reference to FIG. 1, the plurality of second parts 160b may be disposed in the non-display area NA and provided at two opposite sides of the substrate 110 with the display area AA interposed therebetween. Further, the plurality of second parts 160b may extend in a direction different from a direction in which the plurality of first parts 160a extends. For example, the plurality of second parts 160b may extend in a direction perpendicular to the direction in which the plurality of first parts 160a extends. However, the present disclosure is not limited thereto.

With reference to FIG. 1, some of the plurality of second parts 160b are electrically connected to the plurality of first parts 160a disposed in the non-display area NA between the plurality of pad areas and the display area AA, and the remaining second parts 160b are electrically connected to the plurality of first parts 160a disposed in the non-display area NA opposite to the plurality of pad areas. Therefore, the plurality of second parts 160b may transmit the low-potential power voltages to the plurality of first parts 160a disposed in the non-display area NA between the plurality of pad areas and the display area AA and the plurality of first parts 160a disposed in the non-display area NA opposite to the plurality of pad areas.

The third part 160c may connect the plurality of second parts 160b and the pads. That is, the third part 160c may be disposed adjacent to the pad area and connected to the pad. The plurality of second parts 160b may extend from the third part 160c.

The plurality of first assembling lines 121 and the plurality of second assembling lines 122 are disposed in the display area AA.

The plurality of first assembling lines 121 and the plurality of second assembling lines 122 are respectively disposed on the plurality of subpixels and electrically connected to the plurality of low-potential power link lines 160. The plurality of first assembling lines 121 and the plurality of second assembling lines 122 are alternately disposed in the display area AA.

During the process of self-assembling the light-emitting element, the power for self-assembling the plurality of light-emitting elements may be transmitted to the plurality of first assembling lines 121 and the plurality of second assembling lines 122. After the process of manufacturing the display device 100 is completed, the low-potential power voltages may be transmitted to the plurality of light-emitting elements. In this case, the connection of the light-emitting elements to the plurality of first assembling lines 121 and the plurality of second assembling lines 122 may be configured such that one of the plurality of first assembling lines 121 and one of the plurality of second assembling lines 122 are connected to the same light-emitting element among the plurality of light-emitting elements, for example.

With respect to FIG. 1, the plurality of first assembling lines 121 may be electrically connected to the plurality of first parts 160a, which is disposed in the non-display area NA between the plurality of pad areas and the display area AA, among the plurality of first parts 160a. Further, the plurality of second assembling lines 122 may be electrically connected to the plurality of first parts 160a disposed in the non-display area NA opposite to the plurality of pad areas. Therefore, during the process of self-assembling the light-emitting element, different types of power may be transmitted to the plurality of first assembling lines 121 and the plurality of second assembling lines 122.

For example, the plurality of first assembling lines 121 may receive positive (+) voltages from the plurality of first parts 160a disposed in the non-display area NA between the plurality of pad areas and the display area AA. The plurality of second assembling lines 122 may receive negative (-) voltages from the plurality of first parts 160a disposed in the non-display area NA opposite to the plurality of pad areas. Therefore, an electric field is formed between the first and second assembling lines 121 and 122 disposed adjacent to one pixel, such that the plurality of light-emitting elements may be self-assembled.

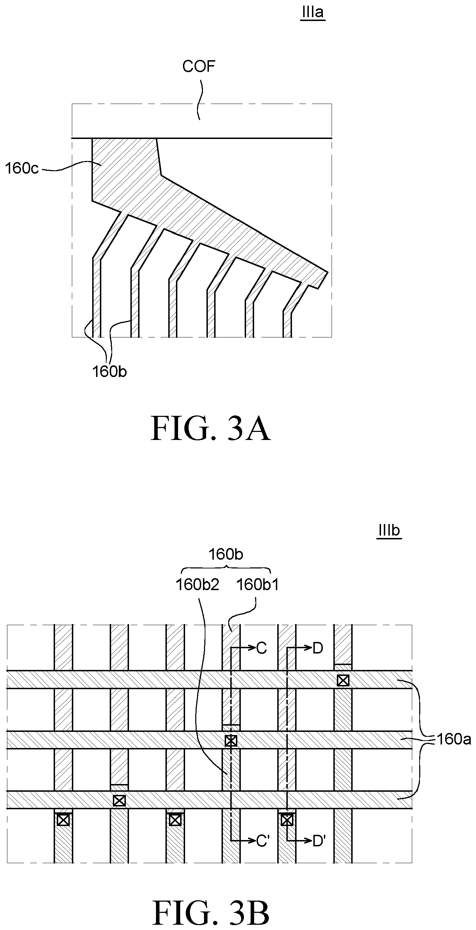

Meanwhile, specific connection between the plurality of low-potential power link lines 160, the plurality of first assembling lines 121, and the plurality of second assembling lines 122 will be described below in detail with reference to FIGS. 3A to 4B.

Hereinafter, a plurality of subpixels SP of a display panel PN of the display device 100 according to the exemplary embodiment of the present specification will be described in more detail.

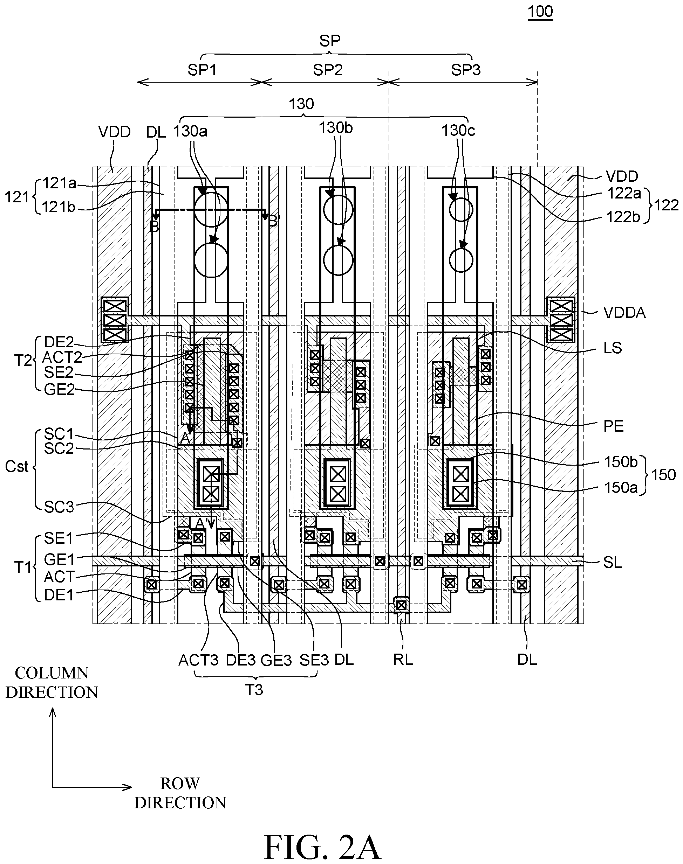

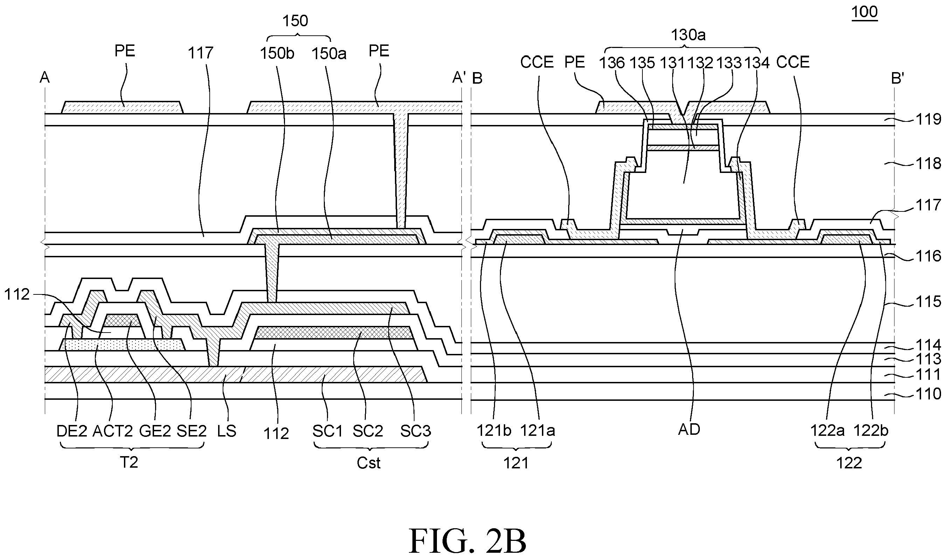

FIG. 2A is an enlarged top plan view of the display device according to the exemplary embodiment of the present specification. FIG. 2B is a cross-sectional view taken along lines A-A' and B-B' in FIG. 2A. With reference to FIGS. 2A and 2B, the plurality of subpixels SP each includes a first transistor T1, a second transistor T2, a third transistor T3, a storage capacitor Cst, and one or more light-emitting elements 130. For convenience of description, in FIG. 2A, hatching patterns of a first assembling electrode 121, a second assembling electrode 122, the light-emitting element 130, and a pixel electrode PE is omitted.

With reference to FIGS. 2A and 2B, the plurality of subpixels SP includes a first subpixel SP1, a second subpixel SP2, and a third subpixel SP3. The first subpixel SP1, the second subpixel SP2, and the third subpixel SP3 may each include the light-emitting element 130 and a circuit and independently emit light. For example, the first subpixel SP1 may be a red subpixel, the second subpixel SP2 may be a green subpixel, and the third subpixel SP3 may be a blue subpixel. However, the present disclosure is not limited thereto.

The display device 100 includes the substrate 110, a buffer layer 111, a gate insulation layer 112, an interlayer insulation layer 113, a first passivation layer 114, a first planarization layer 115, a second passivation layer 116, a third passivation layer 117, a second planarization layer 118, and a fourth passivation layer 119.

First, the substrate 110 is a component for supporting various constituent elements included in the display device 100 and may be made of an insulating material. For example, the substrate 110 may be made of glass, resin, or the like. In addition, the substrate 110 may include plastic such as polymer and may be made of a material having flexibility.

A high-potential power line VDD, a plurality of data lines DL, a reference line RL, a light-blocking layer LS, and a first capacitor electrode SC1 are disposed on the substrate 110.

The high-potential power line VDD is a line that transmits a high-potential power voltage to each of the plurality of subpixels SP. The plurality of high-potential power lines VDD may each transmit the high-potential power voltage to the second transistor T2 of each of the plurality of subpixels SP. The high-potential power line VDD may extend in a column direction between the plurality of subpixels SP. For example, the high-potential power line VDD may be disposed in the column direction between the first subpixel SP1 and the third subpixel SP3. Further, the high-potential power line VDD may transmit the high-potential power voltage to each of the plurality of subpixels SP disposed in a row direction through an auxiliary high-potential power line VDDA.

The plurality of data lines DL is a line that transmits a data voltage Vdata to each of the plurality of subpixels SP. The plurality of data lines DL may each be connected to the first transistor T1 of each of the plurality of subpixels SP. The plurality of data lines DL may extend in the column direction between the plurality of subpixels SP. For example, the data line DL, which extends in the column direction between the first subpixel SP1 and the high-potential power line VDD, may transmit the data voltage Vdata to the first subpixel SP1. The data line DL disposed between the first subpixel SP1 and the second subpixel SP2 may transmit the data voltage Vdata to the second subpixel SP2. The data line DL disposed between the third subpixel SP3 and the high-potential power line VDD may transmit the data voltage Vdata to the third subpixel SP3.

The reference line RL is a line that transmits a reference voltage to each of the plurality of subpixels SP. The reference line RL may be connected to the third transistor T3 of each of the plurality of subpixels SP. The reference line RL may extend in the column direction between the plurality of subpixels SP. For example, the reference line RL may extend in the column direction between the second subpixel SP2 and the third subpixel SP3. Further, a third drain electrode DE3 of the third transistor T3 of each of the first subpixel SP1, the second subpixel SP2, and the third subpixel SP3 disposed adjacent to the reference line RL may extend in the row direction and be electrically connected to the reference line RL.

The light-blocking layer LS is provided on each of the plurality of subpixels SP and disposed on the substrate 110. The light-blocking layer LS may block light, which enters the transistor from a lower side of the substrate 110, and minimize a leakage current. For example, the light-blocking layer LS may block light entering a second active layer ACT2 of the second transistor T2 that is a driving transistor.

The first capacitor electrode SC1 is provided on each of the plurality of subpixels SP and disposed on the substrate 110. The first capacitor electrode SC1, together with other capacitor electrodes, may constitute the storage capacitor Cst. The first capacitor electrode SC1 may be integrated with the light-blocking layer LS.

The buffer layer 111 is disposed on the high-potential power line VDD, the plurality of data lines DL, the reference line RL, the light-blocking layer LS, and the first capacitor electrode SC1. The buffer layer 111 may reduce the penetration of moisture or impurities through the substrate 110. For example, the buffer layer 111 may be configured as a single layer or multilayer made of silicon oxide (SiOx) or silicon nitride (SiNx). However, the present disclosure is not limited thereto. However, the buffer layer 111 may be excluded in accordance with the type of substrate 110 or the type of transistor. However, the present disclosure is not limited thereto.

First, the first transistor T1 is provided on each of the plurality of subpixels SP and disposed on the buffer layer 111. The first transistor T1 is a transistor that transmits the data voltage Vdata to a second gate electrode GE2 of the second transistor T2. The first transistor T1 may be turned on by a scan signal SCAN from a scan line SL. The data voltage Vdata from the data line DL may be transmitted to the second gate electrode GE2 of the second transistor T2 through the first transistor T1 that is turned on. Therefore, the first transistor T1 may be referred to as a switching transistor.

The first transistor T1 includes a first active layer ACT1, a first gate electrode GE1, a first source electrode SE1, and a first drain electrode DE1.

The first active layer ACT1 is disposed on the buffer layer 111. The first active layer ACT1 may be made of a semiconductor material such as an oxide semiconductor, amorphous silicon, or polysilicon. However, the present disclosure is not limited thereto.

The gate insulation layer 112 is disposed on the first active layer ACT1. The gate insulation layer 112 is an insulation layer for insulating the first active layer ACT1 and the first gate electrode GE1. The gate insulation layer 112 may be configured as a single layer or multilayer made of silicon oxide (SiOx) or silicon nitride (SiNx). However, the present disclosure is not limited thereto.

The first gate electrode GE1 is disposed on the gate insulation layer 112. The first gate electrode GE1 may be electrically connected to the scan line SL. The first gate electrode GE1 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The interlayer insulation layer 113 is disposed on the first gate electrode GE1. A contact hole is formed in the interlayer insulation layer 113 so that the first source electrode SE1 and the first drain electrode DE1 are each connected to the first active layer ACT1. The interlayer insulation layer 113 may be an insulation layer for protecting components disposed below the interlayer insulation layer 113. The interlayer insulation layer 113 may be configured as a single layer or multilayer made of silicon oxide (SiOx) or silicon nitride (SiNx). However, the present disclosure is not limited thereto.

The first source electrode SE1 and the first drain electrode DE1 are disposed on the interlayer insulation layer 113 and electrically connected to the first active layer ACT1. The first drain electrode DE1 may be connected to the data line DL and the first active layer ACT1. The first source electrode SE1 may be connected to the first active layer ACT1 and the second gate electrode GE2 of the second transistor T2. The first source electrode SE1 and the first drain electrode DE1 may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The second transistor T2 is provided on each of the plurality of subpixels SP and disposed on the buffer layer 111. The second transistor T2 is a transistor that supplies a drive current to the light-emitting element 130. The second transistor T2 may be turned on and control the drive current flowing to the light-emitting element 130. Therefore, the second transistor T2, which controls the drive current, may be referred to as a driving transistor.

The second transistor T2 includes the second active layer ACT2, the second gate electrode GE2, a second source electrode SE2, and a second drain electrode DE2.

The second active layer ACT2 is disposed on the buffer layer 111. The second active layer ACT2 may be made of a semiconductor material such as an oxide semiconductor, amorphous silicon, or polysilicon. However, the present disclosure is not limited thereto.

The gate insulation layer 112 is disposed on the second active layer ACT2, and the second gate electrode GE2 is disposed on the gate insulation layer 112. The second gate electrode GE2 may be electrically connected to the first source electrode SE1 of the first transistor T1. The second gate electrode GE2 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The interlayer insulation layer 113 is disposed on the second gate electrode GE2. The second source electrode SE2 and the second drain electrode DE2 are disposed on the interlayer insulation layer 113 and electrically connected to the second active layer ACT2. The second drain electrode DE2 may be electrically connected to the second active layer ACT2 and the high-potential power line VDD. The second source electrode SE2 may be electrically connected to the second active layer ACT2 and the light-emitting element 130. The second source electrode SE2 and the second drain electrode DE2 may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The third transistor T3 is provided on each of the plurality of subpixels SP and disposed on the buffer layer 111. The third transistor T3 is a transistor that compensates for a threshold voltage of the second transistor T2. The third transistor T3 is connected between the reference line RL and the second source electrode SE2 of the second transistor T2. The third transistor T3 may be turned on, transmit a reference voltage to the second source electrode SE2 of the second transistor T2, and sense the threshold voltage of the second transistor T2. Therefore, the third transistor T3, which senses the properties of the second transistor T2, may be referred to as a sensing transistor.

The third transistor T3 includes a third active layer ACT3, a third gate electrode GE3, a third source electrode SE3, and the third drain electrode DE3.

The third active layer ACT3 is disposed on the buffer layer 111. The third active layer ACT3 may be made of a semiconductor material such as an oxide semiconductor, amorphous silicon, or polysilicon. However, the present disclosure is not limited thereto.

The gate insulation layer 112 is disposed on the third active layer ACT3, and the third gate electrode GE3 is disposed on the gate insulation layer 112. The third gate electrode GE3 may be electrically connected to the scan line SL. The third gate electrode GE3 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The interlayer insulation layer 113 is disposed on the third gate electrode GE3. The third source electrode SE3 and the third drain electrode DE3 are disposed on the interlayer insulation layer 113 and electrically connected to the third active layer ACT3. The third drain electrode DE3 may be electrically connected to the third active layer ACT3 and the reference line RL. The third source electrode SE3 may be electrically connected to the second source electrode SE2 of the second transistor T2 and the third active layer ACT3. The third source electrode SE3 and the third drain electrode DE3 may each be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Next, a second capacitor electrode SC2 is disposed on the gate insulation layer 112. The second capacitor electrode SC2 may be one of the electrodes that constitute the storage capacitor Cst. The second capacitor electrode SC2 may be disposed to overlap the first capacitor electrode SC1. The second capacitor electrode SC2 may be integrated with the second gate electrode GE2 of the second transistor T2 and electrically connected to the second gate electrode GE2. The first capacitor electrode SC1 and the second capacitor electrode SC2 may be disposed to be spaced apart from each other with the buffer layer 111 and the gate insulation layer 112 interposed therebetween.

Further, the plurality of scan lines SL, the auxiliary high-potential power line VDDA, and a third capacitor electrode SC3 are disposed on the interlayer insulation layer 113.

First, the scan line SL is a line that transmits the scan signal SCAN to each of the plurality of subpixels SP. The scan line SL may extend in the row direction while traversing the plurality of subpixels SP. The scan line SL may be electrically connected to the first gate electrode GE1 of the first transistor T1 and the third gate electrode GE3 of the third transistor T3 of each of the plurality of subpixels SP.

The auxiliary high-potential power line VDDA is disposed on the interlayer insulation layer 113. The auxiliary high-potential power line VDDA may extend in the row direction and be disposed while traversing the plurality of subpixels SP. The auxiliary high-potential power line VDDA may be electrically connected to the high-potential power line VDD that extends in the column direction. The auxiliary high-potential power line VDDA may be electrically connected to the second drain electrode DE2 of the second transistor T2 of each of the plurality of subpixels SP disposed in the row direction.

The third capacitor electrode SC3 is disposed on the interlayer insulation layer 113. The third capacitor electrode SC3 may be an electrode that constitutes the storage capacitor Cst. The third capacitor electrode SC3 may be disposed to overlap the first capacitor electrode SC1 and the second capacitor electrode SC2. The third capacitor electrode SC3 may be integrated with the second source electrode SE2 of the second transistor T2 and electrically connected to the second source electrode SE2. Further, the second source electrode SE2 may also be electrically connected to the first capacitor electrode SC1 through contact holes formed in the interlayer insulation layer 113 and the buffer layer 111. Therefore, the first capacitor electrode SC1 and the third capacitor electrode SC3 may be electrically connected to the second source electrode SE2 of the second transistor T2.

The storage capacitor Cst may store a potential difference between the second gate electrode GE2 and the second source electrode SE2 of the second transistor T2 while the light-emitting element 130 emits light, such that a constant electric current may be supplied to the light-emitting element 130. The storage capacitor Cst is formed on the substrate 110 and formed on the first capacitor electrode SC1, the buffer layer 111, and the gate insulation layer 112 connected to the second source electrode SE2. The storage capacitor Cst is formed on the second capacitor electrode SC2 and the interlayer insulation layer 113 connected to the second gate electrode GE2 and includes the third capacitor electrode SC3 connected to the second source electrode SE2. The storage capacitor Cst may store a voltage between the second gate electrode GE2 and the second source electrode SE2 of the second transistor T2.

The first passivation layer 114 is disposed on the first transistor T1, the second transistor T2, the third transistor T3, and the storage capacitor Cst. The first passivation layer 114 may be an insulation layer for protecting components disposed below the first passivation layer 114. The first passivation layer 114 may be configured as a single layer or multilayer made of silicon oxide (SiOx) or silicon nitride (SiNx). However, the present disclosure is not limited thereto.

The first planarization layer 115 is disposed on the first passivation layer 114. The first planarization layer 115 may planarize an upper portion of the substrate 110 on which the plurality of transistors T1, T2, and T3 and the storage capacitor Cst are disposed. The first planarization layer 115 may be configured as a single layer or multilayer and made of an acrylic-based organic material, for example. However, the present disclosure is not limited thereto.

The second passivation layer 116 is disposed on the first planarization layer 115. The second passivation layer 116 may be an insulation layer for protecting components disposed below the second passivation layer 116. The second passivation layer 116 may be configured as a single layer or multilayer made of silicon oxide (SiOx) or silicon nitride (SiNx). However, the present disclosure is not limited thereto.

A connection part 150, the first assembling electrode 121, and the second assembling electrode 122 are disposed on the second passivation layer 116.

First, the connection part 150 is disposed on each of the plurality of subpixels SP. The connection part 150 is an electrode that electrically connects the second transistor T2 and the pixel electrode PE. The connection part 150 may be electrically connected to the second source electrode SE2 or the third capacitor electrode SC3 through contact holes formed in the second passivation layer 116, the first planarization layer 115, and the first passivation layer 114.

The connection part 150 may have a multilayer structure including a first connection layer 150a and a second connection layer 150b. The first connection layer 150a is disposed on the second passivation layer 116, and the second connection layer 150b is disposed to cover the first connection layer 150a. The second connection layer 150b may be disposed to surround both a top surface and a side surface of the first connection layer 150a. The second connection layer 150b may be made of a material more resistant to corrosion than a material of the first connection layer 150a. Therefore, it is possible to minimize a short-circuit defect caused by migration between lines adjacent to the first connection layer 150a during the process of manufacturing the display device 100. For example, the first connection layer 150a may be made of an electrically conductive material such as copper (Cu) and chromium (Cr). The second connection layer 150b may be made of molybdenum (Mo) and molybdenum titanium (MoTi). However, the present disclosure is not limited thereto.

The first assembling electrode 121 and the second assembling electrode 122 are disposed on the second passivation layer 116. The first assembling electrode 121 and the second assembling electrode 122 are lines that transmit the low-potential power voltage to the light-emitting element 130. Therefore, the first assembling electrode 121 and the second assembling electrode 122 may each be referred to as a low-potential power line. The plurality of first assembling electrodes 121 and the second assembling electrode 122 may be disposed on each of the plurality of subpixels SP and spaced apart from one another while extending in the column direction. For example, the pair of first assembling electrodes 121 and the second assembling electrode 122 may be disposed on each of the first subpixel SP1, the second subpixel SP2, and the third subpixel SP3 and spaced apart from one another at predetermined intervals.

Meanwhile, the first assembling electrode 121 and the second assembling electrode 122 may serve as electrodes for self-assembling the light-emitting element 130. For example, during the process of manufacturing the display device 100, the first assembling electrode 121 and the second assembling electrode 122 may form an electric field to self-assemble the light-emitting element 130.

The first assembling electrode 121 and the second assembling electrode 122 may each include conductive layers 121a and 122a and clad layers 121b and 122b. That is, the first assembling electrode 121 includes a first conductive layer 121a and a first clad layer 121b. The second assembling electrode 122 includes a second conductive layer 122a and a second clad layer 122b.

The conductive layers 121a and 122a of the first and second assembling electrodes 121 and 122 are disposed on the second passivation layer 116. The clad layers 121b and 122b are disposed on the conductive layers 121a and 122a and cover both the top surface and the side surface of the conductive layers 121a and 122a. For example, the conductive layers 121a and 122a may each be made of an electrically conductive material such as copper (Cu) and chromium (Cr). Further, the clad layers 121b and 122b may each be made of a material more resistant to corrosion than materials of the conductive layers 121a and 122a. For example, the clad layers 121b and 122b may each be made of molybdenum (Mo), molybdenum titanium (MoTi), and the like. However, the present disclosure is not limited thereto.

The clad layers 121b and 122b of the first and second assembling electrodes 121 and 122 may be disposed to protrude toward the area in which the plurality of light-emitting elements 130 is disposed. Therefore, the clad layers 121b and 122b are configured to overlap the area in which the plurality of light-emitting elements 130 is disposed, such that the first assembling electrode 121 and the second assembling electrode 122 may serve as the electrodes for self-assembling the light-emitting element 130.

The third passivation layer 117 is disposed on the connection part 150, the first assembling electrode 121, and the second assembling electrode 122. The third passivation layer 117 may be an insulation layer for protecting components disposed below the third passivation layer 117. The third passivation layer 117 may be configured as a single layer or multilayer made of silicon oxide (SiOx) or silicon nitride (SiNx). However, the present disclosure is not limited thereto.

Next, the plurality of light-emitting elements 130 is disposed on the third passivation layer 117. One or more light-emitting elements 130 are disposed on one subpixel SP. The light-emitting element 130 is an element that emits light by receiving an electric current. The light-emitting elements 130 may include the light-emitting elements 130 configured to emit red light, green light, blue light, and the like. The light-emitting elements 130 may implement light with various colors including white by using a combination of red light, green light, blue light, and the like. In addition, light beams with various colors may be implemented by using the light-emitting element 130, which emits light with a particular color, and a photoconversion member that converts the light from the light-emitting element 130 into light with a color different from the particular color. The light-emitting element 130 may be electrically connected between the second transistor T2, the first assembling electrode 121, and the second assembling electrode 122 and emit light by receiving the drive current from the second transistor T2.

In this case, the plurality of light-emitting elements 130 disposed on one subpixel SP may be connected in parallel. That is, one electrode of each of the plurality of light-emitting elements 130 may be connected to the same source electrode of the second transistor T2, and another electrode may be connected to the same assembling electrodes 121 and 122.

Meanwhile, the light-emitting elements 130 respectively disposed on the plurality of subpixels SP may have different structures. For example, the light-emitting elements 130 may include a first light-emitting element 130a, a second light-emitting element 130b, and a third light-emitting element 130c. The first light-emitting element 130a may be disposed on the first subpixel SP1 of the plurality of subpixels SP. The second light-emitting element 130b may be disposed on the second subpixel SP2 of the plurality of subpixels SP. The third light-emitting element 130c may be disposed on the third subpixel SP3 of the plurality of subpixels SP. However, the type of light-emitting element 130 is exemplary. Only any one of the first light-emitting element 130a, the second light-emitting element 130b, and the third light-emitting element 130c may be used as the light-emitting element 130. Alternatively, another type of light-emitting element 130 may be used. However, the present disclosure is not limited thereto. In addition, for convenience of description, FIG. 2A illustrates that two light-emitting elements 130 are disposed on each of the plurality of subpixels SP. The number of light-emitting elements 130 respectively disposed on the plurality of subpixels SP. However, the present disclosure is not limited thereto.

With reference to FIG. 2A, the light-emitting elements 130 respectively disposed on the plurality of subpixels SP may have different sizes. For example, the first light-emitting element 130a, which is disposed on the first subpixel SP1 among the plurality of subpixels SP, may be larger than the second light-emitting element 130b disposed on the second subpixel SP2 and the third light-emitting element 130c disposed on the third subpixel SP3. The second light-emitting element 130b disposed on the second subpixel SP2 may be larger than the third light-emitting element 130c disposed on the third subpixel SP3. However, the present disclosure is not limited thereto.

With reference to FIG. 2B, the plurality of light-emitting elements 130 each includes a first semiconductor layer 131, a light-emitting layer 132, a second semiconductor layer 133, a first electrode 134, a second electrode 135, and a sealing layer 136.

The first semiconductor layer 131 is disposed on the third passivation layer 117, and the second semiconductor layer 133 is disposed on the first semiconductor layer 131. The first semiconductor layer 131 and the second semiconductor layer 133 may each be a layer formed by doping a particular material with n-type and p-type impurities. For example, the first semiconductor layer 131 and the second semiconductor layer 133 may each be a layer formed by doping a material, such as gallium nitride (GaN), indium aluminum phosphide (InAlP), or gallium arsenic (GaAs) with p-type or n-type impurities. Further, the p-type impurity may be magnesium (Mg), zinc (Zn), beryllium (Be), or the like. The n-type impurity may be silicon (Si), germanium (Ge), tin (Sn), or the like. However, the present disclosure is not limited thereto.

A part of the first semiconductor layer 131 may be disposed to protrude to the outside of the second semiconductor layer 133. A top surface of the first semiconductor layer 131 may include a portion, which overlaps a bottom surface of the second semiconductor layer 133, and a portion disposed outside a bottom surface of the second semiconductor layer 133. However, the first semiconductor layer 131 and the second semiconductor layer 133 may be variously modified in sizes and shapes. However, the present disclosure is not limited thereto.

The light-emitting layer 132 is disposed between the first semiconductor layer 131 and the second semiconductor layer 133. The light-emitting layer 132 may emit light by receiving positive holes and electrons from the first semiconductor layer 131 and the second semiconductor layer 133. The light-emitting layer 132 may be configured as a single layer or a multi-quantum well (MQW) structure. For example, the light-emitting layer 132 may be made of indium gallium nitride (InGaN), gallium nitride (GaN), or the like. However, the present disclosure is not limited thereto.

The first electrode 134 is disposed to surround the bottom surface and the side surface of the first semiconductor layer 131. The first electrode 134 is an electrode that electrically connects the first light-emitting element 130 and the assembling electrodes 121 and 122. The first electrode 134 may be made of an electrically conductive material, for example, a transparent conductive material such as indium tin oxide (ITO) or indium zinc oxide (IZO) or an opaque conductive material such as titanium (Ti), gold (Au), silver (Ag), copper (Cu), or an alloy thereof. However, the present disclosure is not limited thereto.

The second electrode 135 is disposed on the top surface of the second semiconductor layer 133. The second electrode 135 is an electrode that electrically connects the pixel electrode PE and the second semiconductor layer 133 that will be described below. The second electrode 135 may be made of an electrically conductive material, e.g., a transparent conductive material such as indium tin oxide (ITO) or indium zinc oxide (IZO). However, the present disclosure is not limited thereto.

The sealing layer 136 is disposed to at least partially surround the first semiconductor layer 131, the light-emitting layer 132, the second semiconductor layer 133, the first electrode 134, and the second electrode 135. The sealing layer 136 may be made of an insulating material and protect the first semiconductor layer 131, the light-emitting layer 132, and the second semiconductor layer 133. The sealing layer 136 may be disposed to cover the light-emitting layer 132, a part of a side surface of the first semiconductor layer 131 adjacent to the light-emitting layer 132, and a part of a side surface of the second semiconductor layer 133 adjacent to the light-emitting layer 132. The first electrode 134 and the second electrode 135 may be exposed from the sealing layer 136. Therefore, a contact electrode CCE, the pixel electrode PE, the first electrode 134, and the second electrode 135, which are formed subsequently, may be electrically connected.

A bonding layer AD is disposed between the plurality of light-emitting elements 130 and the third passivation layer 117. The bonding layer AD may be an organic film that temporarily fixes the light-emitting element 130 during the process of self-assembling the light-emitting element 130. When the organic film is formed to cover the light-emitting element 130 during the process of manufacturing the display device 100, a space between the light-emitting element 130 and the third passivation layer 117 is filled with a part of the organic film, such that the organic film may temporarily fix the light-emitting element 130 onto the third passivation layer 117. Thereafter, even though the organic film is removed, a part of the organic film, which permeates into a lower portion of the light-emitting element 130, may remain without being removed, thereby defining the bonding layer AD. The bonding layer AD may be made of an organic material, for example, an acrylic-based organic material. However, the present disclosure is not limited thereto.

The contact electrode CCE is disposed on the side surface of the light-emitting element 130, the first assembling electrode 121, and the second assembling electrode 122. With reference to FIG. 2B, the contact electrode CCE is disposed on the side surface of the light-emitting element 130 and the clad layers 121b and 122b of the first and second assembling electrodes 121 and 122 that are exposed from the third passivation layer 117.

The contact electrode CCE is an electrode that electrically connects the light-emitting element 130 and the first and second assembling electrodes 121 and 122. Therefore, the contact electrode CCE electrically connects the first electrode 134 of the light-emitting element 130 and the first and second assembling electrodes 121 and 122.

Next, the second planarization layer 118 is disposed on the light-emitting element 130 and the contact electrode CCE. The second planarization layer 118 may planarize the upper portion of the substrate 110 on which the light-emitting element 130 is disposed. The second planarization layer 118, together with the bonding layer AD, may fix the light-emitting element 130 onto the substrate 110. The second planarization layer 118 may be configured as a single layer or multilayer and made of an acrylic-based organic material, for example. However, the present disclosure is not limited thereto.

The fourth passivation layer 119 is disposed on the second planarization layer 118. The fourth passivation layer 119 may be an insulation layer for protecting components disposed below the fourth passivation layer 119. The fourth passivation layer 119 may be configured as a single layer or multilayer made of silicon oxide (SiOx) or silicon nitride (SiNx). However, the present disclosure is not limited thereto. In this case, the fourth passivation layer 119 is not an essential component and may be excluded in accordance with design.

The pixel electrode PE is disposed on the fourth passivation layer 119.

The pixel electrode PE may be an electrode that electrically connects the plurality of light-emitting elements 130 and the connection part 150. The pixel electrode PE is electrically connected to the plurality of light-emitting elements 130. Specifically, the pixel electrode PE may be electrically connected to the light-emitting element 130, the connection part 150, and the second transistor T2 through contact holes formed in the second planarization layer 118 and the fourth passivation layer 119. Therefore, the second electrode 135 of the light-emitting element 130, the connection part 150, the second source electrode SE2 of the second transistor T2 may be electrically connected through the pixel electrode PE. The pixel electrode PE may be made of an electrically conductive material, e.g., a transparent conductive material such as indium tin oxide (ITO) or indium zinc oxide (IZO). However, the present disclosure is not limited thereto.

Hereinafter, specific connection between the plurality of low-potential power link lines 160, the plurality of first assembling lines 121, and the plurality of second assembling lines 122 will be described in more detail with reference to FIGS. 3A to 4B.

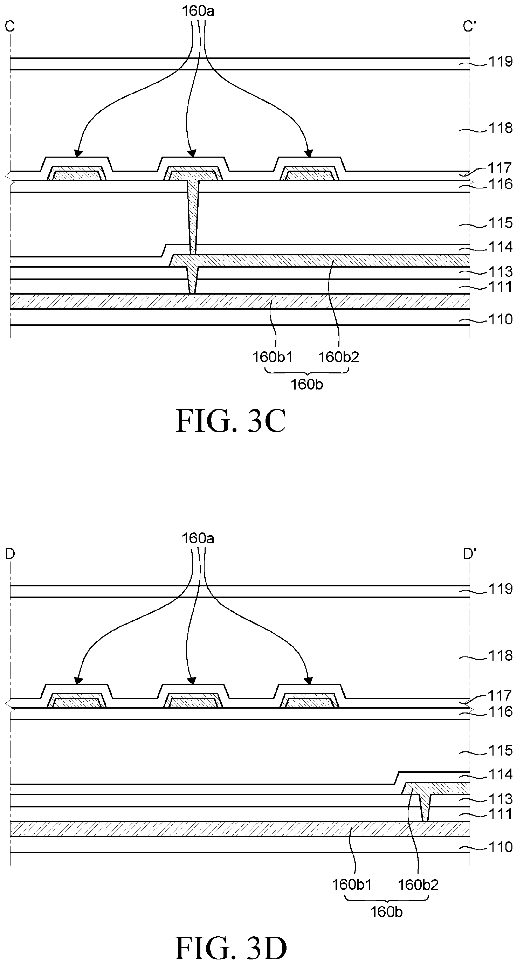

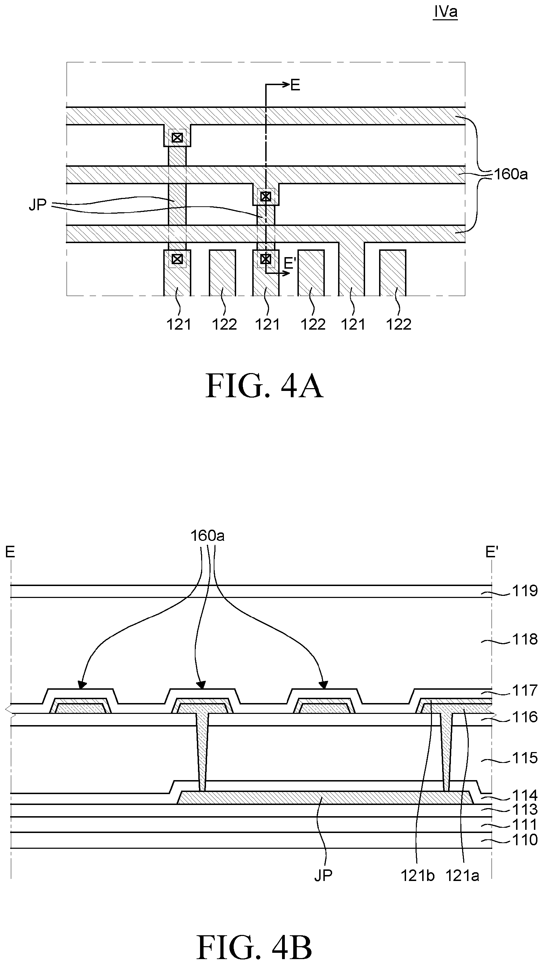

FIG. 3A is an enlarged top plan view of area IIIa in FIG. 1. FIG. 3B is an enlarged top plan view of area IIIb in FIG. 1. FIG. 3C is a cross-sectional view taken along line C-C' in FIG. 3B. FIG. 3D is a cross-sectional view taken along line D-D' in FIG. 3B. FIG. 4A is an enlarged top plan view of area IVa in FIG. 1. FIG. 4B is a cross-sectional view taken along line E-E' in FIG. 4A. For convenience of description, FIGS. 3A and 3B illustrate only the low-potential power link line 160 and the flexible film COF among various constituent elements of the display device 100. FIG. 4A illustrates only the low-potential power link line 160 and a jumping pattern JP.

With reference to FIG. 3A, one low-potential power link line 160 may include the plurality of second parts 160b and the third part 160c. The third part 160c is connected directly to one pad. The plurality of second parts 160b is formed to extend from the third part 160c. Therefore, the same voltage may be applied to the plurality of second parts 160b through the third part 160c. In this case, the third part 160c may be made of the same material as the second part 160b. For example, the third part 160c may be made of the same material as the light-blocking layer LS in the display area AA.

With reference to FIGS. 3B to 3D, the plurality of second parts 160b includes a first layer 160b1 and a second layer 160b2.

The first layer 160b1 is a component disposed at a lowermost side of the plurality of second parts 160b. The first layer 160b1 is disposed in the entire area of the plurality of second parts 160b. That is, a portion of the low-potential power link line 160, which is connected to the pad in the pad area, may be the first layer 160b1.

The first layer 160b1 is made of the same material as the light-blocking layer LS in the display area AA. The first layer 160b1 may be made of the same layer and made by the same process as the light-blocking layer LS in the display area AA. However, the present disclosure is not limited thereto.

The second layer 160b2 is partially disposed on the first layer 160b1 and disposed only at a left or right side of the display area AA. The second layer 160b2 is disposed on the first layer 160b1 along the first layer 160b1 and electrically connected to the first layer 160b1. The second layer 160b2 may be electrically connected to the first layer 160b1 through contact holes formed in the buffer layer 111 and the interlayer insulation layer 113. Therefore, the second layer 160b2 may be connected in parallel to the first layer 160b1.

Meanwhile, the second layer 160b2 disposed on the first layer 160b1 may be configured to be electrically connected to the first layer 160b1 multiple times. Therefore, contact resistance between the first layer 160b1 and the second layer 160b2 may be minimized. However, the method of electrically connecting the first layer 160b1 and the second layer 160b2 is not limited thereto.

The second layer 160b2 is made of the same material as the first source electrode SE1 and the first drain electrode DE1. The second layer 160b2 may be formed on the same layer and made by the same process as the first source electrode SE1 and the first drain electrode DE1. However, the present disclosure is not limited thereto.

With reference to FIGS. 3B to 3D, the plurality of first parts 160a is disposed on the second layer 160b2 of the plurality of second parts 160b. The plurality of first parts 160a is disposed in a direction in which the plurality of first parts 160a intersects the second part 160b.

The plurality of first parts 160a may be made of the same material as the first and second assembling electrodes 121 and 122 and the connection part 150 disposed in the display area AA. Therefore, as illustrated in FIGS. 3C and 3D, the plurality of first parts 160a may each have a multilayer structure. However, the present disclosure is not limited thereto.

The plurality of first parts 160a may be electrically connected to the plurality of second parts 160b and receive the low-potential power voltages from the plurality of second parts 160b. The plurality of first parts 160a may transmit the low-potential power voltages to the plurality of light-emitting elements. The plurality of first parts 160a is electrically connected to the second layer 160b2 of the plurality of second parts 160b.

Specifically, as illustrated in FIG. 3C, in the portion where the plurality of first parts 160a and the plurality of second parts 160b are electrically connected, the first part 160a is electrically connected to the second layer 160b2 of the second part 160b through contact holes formed in the first passivation layer 114, the first planarization layer 115, and the second passivation layer 116. Further, as illustrated in FIG. 3D, in the portion where the plurality of first parts 160a and the plurality of second parts 160b are not electrically connected, the first part 160a and the second part 160b may be electrically insulated by the first passivation layer 114, the first planarization layer 115, and the second passivation layer 116 without being connected.

With reference to FIG. 4A, the plurality of first assembling lines 121 and the plurality of second assembling lines 122 extend in a direction perpendicular to a direction in which the plurality of first parts 160a extends. Further, at least some of the plurality of second parts 160b are disposed to be parallel to the extension direction of the plurality of first assembling lines 121 and the plurality of second assembling lines 122.

The plurality of first assembling lines 121 and the plurality of second assembling lines 122 are electrically connected to the plurality of first parts 160a and disposed on the same layer as the plurality of first parts 160a. For example, the plurality of first assembling lines 121 and the plurality of second assembling lines 122 may be formed to electrically branch off from the plurality of first parts 160a.

For example, the plurality of first assembling lines 121 may be electrically connected to the plurality of first parts 160a disposed in the non-display area NA between the plurality of pad areas and the display area AA. The plurality of second assembling lines 122 may be electrically connected to the first part 160a disposed in the non-display area NA opposite to the plurality of pad areas.

Therefore, the plurality of first assembling lines 121 and the plurality of second assembling lines 122 may receive self-assembling power or low-potential power voltages from the plurality of first parts 160a and form an electric field to self-assemble the plurality of light-emitting elements or transmit the low-potential power voltages to the plurality of light-emitting elements.

With reference to FIGS. 4A and 4B, the plurality of first assembling lines 121 and the plurality of second assembling lines 122 are disposed so as not to be electrically connected to the first and second assembling lines 121 and 122 disposed in different columns.

Specifically, the plurality of first assembling lines 121 and the plurality of second assembling lines 122 may be electrically connected to the plurality of first parts 160a through the jumping pattern JP.

For example, the jumping pattern JP may be made of the same material as the first source electrode SE1 and the first drain electrode DE1. The jumping pattern JP may be formed on the same layer and made by the same process as the first source electrode SE1 and the first drain electrode DE1. However, the present disclosure is not limited thereto.

The jumping pattern JP may be disposed on a layer different from the layers on which the plurality of first assembling lines 121 and the plurality of second assembling lines 122 are disposed. Therefore, the first assembling line 121 and the plurality of second assembling lines 122 may be configured not to be electrically connected.

As the jumping pattern JP is used, the plurality of first assembling lines 121, the plurality of second assembling lines 122, and the plurality of first parts 160a may be made of the same material and formed on the same layer.

One or more first parts, among the plurality of first parts 160a, may be connected to the jumping pattern JP so as to be electrically connected to the plurality of first assembling lines 121 or the plurality of second assembling lines 122. The plurality of first parts 160a connected to the jumping pattern JP may include contact portions partially protruding in the direction of the plurality of first assembling lines 121 or the plurality of second assembling lines 122. The plurality of first parts 160a may be connected to the jumping pattern JP through contact holes disposed in the contact portions.

Alternatively, contact holes may be disposed in the plurality of first parts 160a so that the plurality of first parts 160a is connected to the jumping pattern JP. However, the present disclosure is not limited thereto.

In addition, the plurality of first assembling lines 121 or the plurality of second assembling lines 122 may extend and be connected to the first part 160a that does not require jumping, i.e., the first part 160a that does not intersect another first part 160a.

FIG. 5 is a schematic configuration view for explaining a process of manufacturing the display device according to the exemplary embodiment of the present specification. FIG. 5 is a view for explaining a self-assembling process using a mother substrate 110' used for the process of manufacturing the display device 100. For convenience of description, FIG. 5 illustrates only the mother substrate 110', the display area AA, the non-display area NA, the plurality of low-potential power link lines 160, the plurality of first assembling lines 121, the plurality of second assembling lines 122, and a plurality of assembling pads AP among various constituent elements of the display device 100.

With reference to FIG. 5, the assembling pad AP and the plurality of first parts 160a of the plurality of low-potential power link lines 160 are disposed on the mother substrate 110'.

The plurality of first parts 160a of the plurality of low-potential power link lines 160 is disposed in the non-display area NA between the plurality of pad areas and the display area AA or disposed in the non-display area NA opposite to the plurality of pad areas.

The assembling pads AP are disposed at two opposite ends of each of the plurality of first parts 160a. The assembling pad AP is a component used only for the process of self-assembling the light-emitting element. After the process of manufacturing the display device 100 is completed, the assembling pad AP may be cut along a cutting line SP together with the mother substrate 110' and removed.

The assembling pad AP may transmit an assembling voltage, for self-assembling the light-emitting element, to each of the plurality of first parts 160a during the process of self-assembling the light-emitting element. Further, the plurality of first parts 160a may form an electric field so that the light-emitting elements are assembled on the plurality of first assembling lines 121 and the plurality of second assembling lines 122. For example, the assembling pads AP connected to the plurality of first parts 160a disposed in the non-display area NA between the plurality of pad areas and the display area AA may transmit positive (+) voltages to the plurality of first parts 160a and apply negative (-) voltages to the plurality of first parts 160a disposed in the non-display area NA opposite to the plurality of pad areas. However, the present disclosure is not limited thereto.

As various lines are disposed on the display device, the line may have a plurality of layers in an area in which one line intersects another line in order to transmit particular signals or voltages to the constituent elements disposed in the display area. In this case, in case that a layer made of a high-resistance material, such as a transparent electrode, is present among the plurality of layers, the resistance of the line may increase. In particular, in case that the resistance of the layers constituting the low-potential power link line increases, a voltage drop occurs with respect to the low-potential power voltage, which may cause a brightness deviation for each area in the display area and increase power consumption.

According to the display device 100 according to the exemplary embodiment of the present specification, the low-potential power link line 160, which applies the low-potential power voltages to the plurality of light-emitting elements 130, may be made of the same material as the constituent elements disposed in the drive circuit, thereby minimizing the resistance of the low-potential power link line 160. As described above, the first part 160a, the second part 160b, and the third part 160c of the low-potential power link line 160 may each be made of the same material as at least one of the light-blocking layer LS, the first source electrode SE1, the first drain electrode DE1, and the assembling lines 121 and 122 disposed in the display area AA that are made of a metallic material. Therefore, the low-potential power link line 160 may be made of only the metallic material instead of a transparent electrically conductive material. Therefore, in the display device 100 according to the exemplary embodiment of the present disclosure, the low-potential power link line 160 may be made of a metallic material having low resistance, thereby reducing a voltage drop with respect to the low-potential power voltage. Therefore, it is possible to minimize a brightness deviation for each area in the display area AA and reduce power consumption.

In addition, in the display device 100 according to the exemplary embodiment of the present disclosure, the plurality of low-potential power link lines 160 may be provided, thereby additionally reducing a voltage drop with respect to the low-potential power voltage. That is, as described above, the low-potential power voltage may be applied to one light-emitting element 130 through the two assembling lines 121 and 122, and the low-potential power voltage may be applied to the two assembling lines 121 and 122 through the separate low-potential power link line 160. In addition, the assembling lines 121 and 122, which are respectively disposed on the first subpixel SP1, the second subpixel SP2, and the third subpixel SP3, are connected to the different low-potential power link lines 160. Therefore, in the display device 100 according to the exemplary embodiment of the present disclosure, a total of six low-potential power link lines 160 are used. Therefore, it is possible to reduce the resistance of the low-potential power link line 160 and thus further reduce a voltage drop with respect to the low-potential power voltage in comparison with a case in which a single low-potential power link line is used for all the subpixels SP.

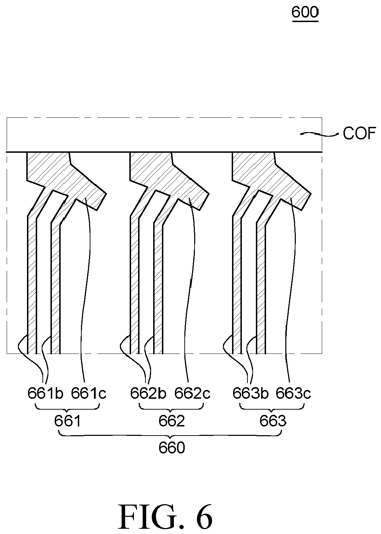

FIG. 6 is an enlarged top plan view of a display device according to another exemplary embodiment of the present specification. A display device 600 in FIG. 6 is substantially identical in configuration to the display device 100 in FIGS. 1 to 5, except for a low-potential power link line 660. Therefore, repeated descriptions of the identical components will be omitted. For convenience of illustration, FIG. 6 does not illustrate a first part of the low-potential power link line 660. However, because the first part of the low-potential power link line 660 in FIG. 6 is identical to the first part 160a of the low-potential power link line 160 in FIGS. 1 to 5, a repeated description thereof will be omitted.

The plurality of low-potential power link lines 660 may include a first low-potential power link line 661, a second low-potential power link line 662, and a third low-potential power link line 663.

The first low-potential power link lines 661 may be electrically connected to the light-emitting elements 130 of the plurality of first subpixels SP1. That is, the first low-potential power link lines 661 may be connected to the assembling lines 121 and 122 disposed on the plurality of first subpixels SP1 and transmit the low-potential power voltages to the light-emitting elements 130 of the plurality of first subpixels SP1.

The first low-potential power link line 661 may include the first part, a second part 661b, and a third part 661c. The plurality of first parts may be respectively disposed in the non-display area NA between the plurality of pad areas and the display area AA and in the non-display area NA opposite to the plurality of pad areas. The second part 661b may be connected to the first part. The second parts 661b may be disposed in the non-display area NA at two opposite sides of the display area AA so as to extend in a direction perpendicular to a direction in which the first part extends. The third part 661c may extend from the pad and be connected to the second part 661b.

The second low-potential power link lines 662 may be electrically connected to the light-emitting elements 130 of the plurality of second subpixels SP2. That is, the second low-potential power link lines 662 may be connected to the assembling lines 121 and 122 disposed on the plurality of second subpixels SP2 and transmit the low-potential power voltages to the light-emitting elements 130 of the plurality of second subpixels SP2.

The second low-potential power link line 662 may include the first part, a second part 662b, and a third part 662c. The plurality of first parts may be respectively disposed in the non-display area NA between the plurality of pad areas and the display area AA and in the non-display area NA opposite to the plurality of pad areas. The second part 662b may be connected to the first part. The second parts 662b may be disposed in the non-display area NA at two opposite sides of the display area AA so as to extend in a direction perpendicular to a direction in which the first part extends. The third part 662c may extend from the pad and be connected to the second part 662b.

The third low-potential power link lines 663 may be electrically connected to the light-emitting elements 130 of the plurality of third subpixels SP3. That is, the third low-potential power link lines 663 may be connected to the assembling lines 121 and 122 disposed on the plurality of third subpixels SP3 and transmit the low-potential power voltages to the light-emitting elements 130 of the plurality of third subpixels SP3.

The third low-potential power link line 663 may include the first part, a second part 663b, and a third part 663c. The plurality of first parts may be respectively disposed in the non-display area NA between the plurality of pad areas and the display area AA and in the non-display area NA opposite to the plurality of pad areas. The second part 663b may be connected to the first part. The second parts 663b may be disposed in the non-display area NA at two opposite sides of the display area AA so as to extend in a direction perpendicular to a direction in which the first part extends. The third part 663c may extend from the pad and be connected to the second part 663b.

Different low-potential power voltages may be applied to the first low-potential power link line 661, the second low-potential power link line 662, and the third low-potential power link line 663. As illustrated in FIG. 6, the third part 661c of the first low-potential power link line 661, the third part 662c of the second low-potential power link line 662, and the third part 663c of the third low-potential power link line 663 may be disposed to be spaced apart from one another. Therefore, the third part 661c of the first low-potential power link line 661, the third part 662c of the second low-potential power link line 662, and the third part 663c of the third low-potential power link line 663 may be connected to different pads or electrically separated. Therefore, different low-potential power voltages may be applied to the first low-potential power link line 661, the second low-potential power link line 662, and the third low-potential power link line 663.

According to the display device 600 according to another exemplary embodiment of the present specification, the low-potential power link line 660, which applies the low-potential power voltages to the plurality of light-emitting elements 130, may be made of the same material as the constituent elements disposed in the drive circuit, thereby minimizing the resistance of the low-potential power link line 660. Therefore, in the display device 600 according to another exemplary embodiment of the present disclosure, the low-potential power link line 660 may be made of a metallic material having low resistance, thereby reducing a voltage drop with respect to the low-potential power voltage, minimizing a brightness deviation for each area in the display area AA, and reducing power consumption.

In addition, in the display device 600 according to another exemplary embodiment of the present disclosure, the plurality of low-potential power link lines 660 may be provided, thereby additionally reducing a voltage drop with respect to the low-potential power voltage. Therefore, in the display device 600 according to another exemplary embodiment of the present disclosure, a total of six low-potential power link lines 660 are used. Therefore, it is possible to reduce the resistance of the low-potential power link line 660 and thus further reduce a voltage drop with respect to the low-potential power voltage in comparison with a case in which a single low-potential power link line is used for all the subpixels SP.

In addition, in the display device 600 according to another exemplary embodiment of the present disclosure, the low-potential power link lines 660 connected to the different subpixels SP may be electrically separated and independently apply the low-potential power voltages to the different subpixels. That is, the third part 661c of the first low-potential power link line 661, the third part 662c of the second low-potential power link line 662, and the third part 663c of the third low-potential power link line 663 are connected to different pads, such that the low-potential power voltages may be independently applied to the first low-potential power link line 661, the second low-potential power link line 662, and the third low-potential power link line 663. Therefore, in the display device 600 according to another exemplary embodiment of the present disclosure, the low-potential power voltages may be independently applied in accordance with the properties of the light-emitting elements 130 disposed on the subpixels SP that emit light beams with different colors. Therefore, it is possible to control the low-potential voltage for each of the light-emitting elements 130.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims, and all the technical concepts in the equivalent scope thereof should be construed as falling within the scope of the present disclosure.

## Claims

1. A display device comprising:
a substrate (110) comprising a display area (AA) in which a plurality of subpixels (SP) is disposed, and a non-display area (NA) disposed adjacent to the display area (AA) and comprising a plurality of pad areas;
a plurality of pads disposed in the plurality of pad areas;
a plurality of low-potential power link lines (160) electrically connected to the pads disposed in leftmost and rightmost areas among the plurality of pad areas;
a plurality of first assembling lines (121) and a plurality of second assembling lines (122) respectively disposed on the plurality of subpixels (SP) and electrically connected to the plurality of low-potential power link lines (160); and
a plurality of light-emitting elements (130) disposed on the plurality of first assembling lines (121) and the plurality of second assembling lines (122),
wherein each of the plurality of low-potential power link lines (160) comprises:
a first part (160a) connected to the plurality of first assembling lines (121) and/or the plurality of second assembling lines (122); and
a second part (160b) configured to transmit a low-potential power voltage to the first part (160a).

2. The display device of claim 1, wherein the plurality of pad areas is positioned at an upper side of the display area (AA),
wherein the first part (160a) is disposed in the non-display area (NA) between the plurality of pad areas and the display area (AA) or in the non-display area (NA) opposite to the plurality of pad areas, and
wherein the second part (160b) is disposed in the non-display area (NA) at left and right sides of the display area (AA).

3. The display device of claim 1 or 2, wherein an extension direction of the first part (160a) intersects an extension direction of the plurality of first assembling lines (121) and an extension direction of the plurality of second assembling lines (122), and/or
wherein at least a part of the second part (160b) is parallel to the extension direction of the plurality of first assembling lines (121) and the extension direction of the plurality of second assembling lines (122).

4. The display device of any one of the preceding claims, further comprising:
a plurality of transistors (T) disposed on the plurality of subpixels (SP) and each comprising a gate electrode (GE), a source electrode (SE), a drain electrode (DE), and an active layer (ACT); and
a light-blocking layer (LS) disposed between the plurality of transistors (T) and the substrate (110),
wherein the plurality of low-potential power link lines (160) is made of the same material as at least one of the light-blocking layer (LS), the source electrode (SE), the drain electrode (DE), the plurality of first assembling lines (121), and the plurality of second assembling lines (122).

5. The display device of claim 4, wherein the first part (160a) is made of the same material as the plurality of first assembling lines (121) and the plurality of second assembling lines (122), and
wherein the second part (160b) comprises:
a first layer (160b1) made of the same material as the light-blocking layer (LS); and
a second layer (160b2) connected in parallel to the first layer (160b1) and made of the same material as the source electrode (SE) and the drain electrode (DE).

6. The display device of any one of the preceding claims, wherein some of the plurality of first assembling lines (121) comprise a jumping pattern (JP) disposed in an area in which some of the plurality of first assembling lines (121) intersect another first assembling line (121), and
wherein some of the plurality of second assembling lines (122) comprise a jumping pattern (JP) disposed in an area in which some of the plurality of second assembling lines intersect another second assembling line (122).

7. The display device of claim 5 or 6, wherein the first layer (160b1) is disposed on an entire area of the second part (160b), and the second layer (160b2) is disposed only at a left or right side of the display area (AA).

8. The display device of any one of the preceding claims, wherein the plurality of first assembling lines (121) is connected to the first part (160a) of each of the plurality of low-potential power link lines (160) disposed in the non-display area (NA) between the plurality of pad areas and the display area (AA),
wherein the plurality of second assembling lines (122) is connected to the first part (160a) of each of the plurality of low-potential power link lines (160) disposed in the non-display area (NA) opposite to the plurality of pad areas.

9. The display device of any one of the preceding claims, wherein the plurality of first assembling lines (121) and the plurality of second assembling lines (122) are alternately disposed in the display area (AA).

10. The display device of any one of the preceding claims, wherein one of the plurality of first assembling lines (121) and one of the plurality of second assembling lines (122) are connected to the same light-emitting element (130) among the plurality of light-emitting elements.

11. The display device of any one of the preceding claims, wherein the plurality of low-potential power link lines (160) each further comprises a third part (160c) connected directly to the pad.

12. The display device of any one of the preceding claims, wherein the third parts (160c) are configured to apply the same voltages to the second parts (160b) of the plurality of low-potential power link lines (160).

13. The display device of any one of the preceding claims, wherein the plurality of subpixels (SP) comprises a plurality of first subpixels (SP1), a plurality of second subpixels (SP2), and a plurality of third subpixels (SP3),
wherein the plurality of low-potential power link lines (160) comprises:
a first low-potential power link line (661) electrically connected to the light-emitting element (130) of each of the plurality of first subpixels (SP1);
a second low-potential power link line (662) electrically connected to the light-emitting element (130) of each of the plurality of second subpixels (SP2); and
a third low-potential power link line (663) electrically connected to an element of each of the plurality of third subpixels (SP3), and
wherein different voltages are applied to the first low-potential power link line (661), the second low-potential power link line (662), and the third low-potential power link line (663).

14. The display device of claim 13, wherein each of the plurality of low-potential power link lines (661, 662, 663) further comprises a plurality of third parts (661c, 662c, 663c) connected to the second part (661b, 662b, 663b), and
wherein the third part (661c) of the first low-potential power link line (661), the third part (662c) of the second low-potential power link line (662), and the third part (663c) of the third low-potential power link line (663) are connected to different pads.

15. The display device of any one of the preceding claims, further comprising:
a planarization layer (115, 118) configured to cover the plurality of low-potential power link lines (160); and
a plurality of pixel electrodes (PE) disposed on the planarization layer (115, 118) and connected to the plurality of light-emitting elements (130).
